# EUROPEAN PATENT SPECIFICATION

(11) **EP 3 096 351 B1**
(45) Date of publication and mention of the grant of the patent: **13.12.2017**
(21) Application number: 15168863.7
(22) Date of filing: 22.05.2015
(51) Int. Cl.: H01L 23/373, H01L 23/42

(54) **THERMAL INTERFACE FOIL**
THERMISCHER GRENZFLÄCHENFILM
FILM D'INTERFACE THERMIQUE

(43) Date of publication of application: 23.11.2016
(73) Proprietor: ABB Technology Oy, 00380 Helsinki (FI)
(72) Inventor: Manninen, Jorma, 00380 Helsinki (FI); Silvennoinen, Mika, 00380 Helsinki (FI); Mörsky, Heikki, 00380 Helsinki (FI)
(74) Representative: Kolster Oy Ab

(56) References cited:
- EP-A2- 2 711 982
- JP-A- 2010 212 543
- JP-A- 2015 065 330
- Co ET AL: "T-Global Technology T-GLOBAL TECHNOLOGY CO.,LTD", , 2 December 2013 (2013-12-02), XP055227022, Retrieved from the Internet: URL:http://web.archive.org/web/20150423050 039/http://www.tglobalthermal.com/pdf/MSDS -L37-5S.pdf [retrieved on 2015-11-09]

## Description

### FIELD OF THE INVENTION

The present invention relates to power electronics components, and more particularly to thermal interface materials to be used in connection with power electronics components.

### BACKGROUND OF THE INVENTION

Power electronic modules are widely used components in which multiple of power electronic switches or devices are placed in a single module. The switches of a power electronic module are wired inside the module in specified manner such that power electronic modules can be used in different circuit structures. Such circuit structures are, for example, power stages of different power converters. For that purpose, the power electronic modules may comprise different half-bridge, full bridge or other bridge topologies in which controllable switch components are internally connected with power diodes. The power electronic modules comprise also terminals, such as control terminals and power terminals that allow connecting the modules to other required circuitry and possibly to other modules.

The components inside a power electronic module are typically mounted on a substrate that is thermally connected to the base plate of the module. The base plate is a metallic piece integrated to the bottom of the module and it is intended to be attached to a surface of a cooling member, such as heat sink. The semiconductor switches inside the modules generate heat when the switches are operated. The switched currents can be over hundreds or even thousands of amperes and the voltage blocking ability of the power semiconductors of the module is several thousand volts. These semiconductor switches are further operated at a relatively high frequency of several thousand Hertz.

Power electronic modules are also fabricated without a base plate and the bottom surface of the module is then formed of the substrate. Such modules are constructed typically using smaller pieces of semiconductors switches that are spread out on the substrate. As the semiconductors that generate the heat are spread, the heat is also generated evenly and a base plate is not required for spreading the heat. Power electronic modules without a base plate are attached to a cooling member such that the heat is transferred from the substrate to the cooling member.

A proper thermal design is crucial for a reliable operation of power electronic modules. A violation of the temperature ratings can lead to a reduced safe operating area and consequently a sudden device failure or to a reduced operational lifetime. For example, IEC 60747-9 gives a range of temperature ratings for IGBTs like storage temperature, case temperature and virtual junction temperature. To keep the temperature of the module at a tolerable range, it is known to attach the module to a heat sink. This is performed by attaching the planar surface of the baseplate or of the substrate to a corresponding planar surface of a heat sink. The heat transfer between the bottom surface of the module and the heat sink is enhanced by using a thermal interface material (TIM). Such material or layer is placed between the surfaces of base plate and heat sink or surfaces of substrate and heat sink if the module is without a base plate.

Thermal connection between two surfaces depends on several properties including their surface roughness (Ra) and surfaces' planarity. In practice the contact of two surfaces is imperfect and there are gaps filled with air in between them. Because air is poor thermal conductor the contact thermal resistance (Rth) can be reduced by making the contact surfaces perfectly smooth and planar (very expensive) and/or by replacing the air by a better thermal conducting substance.

Specific materials have been developed to fill air gaps between the surfaces in contact and to reduce contact thermal resistance. These thermal interface materials are available in different physical forms like dispensable grease or paste, various thickness rubber like pads, metal foils and so on. These materials are typically mixtures that include carrier or substrate chemical (like silicone oil or rubber) that has been filled with higher thermal conducting material like boron nitride or carbon nanotubes. Some TIMs have also phase changing property, which may be beneficial for example in cyclic operation applications. This type of TIM is proven to work well in many applications where the contact surface area is relatively small and planar like with cooling of CPUs. Another working solution for CPUs and similar small footprint and planar surfaces is the use of graphite thermal interface materials. Known graphite TIMs have high temperature conductivity and are suitable for small footprint devices due to hardness of the material.

However, the base plate footprint size of PE modules is several times larger compared to CPU's footprint size. Also the base plate surface profile is far from planar in power electronic modules. The base plate's deviation from flatness may exceed 0.1 mm (>100 µm) over 50mm length. This initial out-of-planarity causes uneven contact pressure at module mounting. Temperature gradient, power cycling and coefficient of thermal expansion differences within the materials of PE module cause dynamic variation to the thermal interface shape. This dynamic behavior causes complex deformation scenario to the thermal interface, which loads the TIM, and in many cases destroys TIM's capability to carry out the heat conduction function. For greases this means "pump-out" where grease is leaking away and for foils this means rupture and dropping pieces of foil. The above power cycling refers to uses of the power electronic module in which the loading of the module is periodical. The periodical or cyclic loading means further that the temperature of the module changes according to the cyclic loading.

Document JP2015 065330A discloses a power electronic assembly in which an aluminium foil having a polymer coating is used as a thermal interface material.

The problem is that power electronic module's cooling recedes with time because of reducing thermal contact between the module's base plate and adjacent cooling surface of the heat sink. Power electronic module operation induces thermo-mechanical forces that deform the base plate that leads to deformation of thermal interface material. This in turn may increase thermal resistance in base plate - heat sink interface, which causes power electronic module chip temperatures to rise and the module to fail early.

In addition to the dynamics induced by power cycling, it has been noticed that the PE module experiences permanent deformation during operation. The consequence is that TIM must be able to adhere to not only dynamics but also the changes in static shape of thermal interface.

### BRIEF DESCRIPTION OF THE INVENTION

An object of the present invention is to provide a power electronic assembly and a method for producing the assembly so as to solve the above problems. The objects of the invention are achieved by an assembly and method which are characterized by what is stated in the independent claims. The preferred embodiments of the invention are disclosed in the dependent claims.

The invention is based on the idea of employing multiple sheets of aluminium having polymer coatings as a thermal interface material or sheet.

A thermal interface material layer consisting of aluminium with polymer coating produces a reliable interface layer as the aluminium is known to have good thermal conductivity. The polymer coating of the aluminium sheet provides also good thermal conductivity with the ability to make a reliable contact between the bottom surface of the power electronic module and the surface of the cooling arrangement. The polymer layer is further relatively soft such that it fills possible gaps or deformations in baseplate and the surface of the cooling arrangement.

Aluminium sheet with a polymer coating is also very cost-effective structure as the manufacture of such a sheet is easy and the unit cost is relatively low.

### BRIEF DESCRIPTION OF THE DRAWINGS

In the following the invention will be described in greater detail by means of preferred embodiments with reference to the attached drawings, in which
Figure 1 shows a basic structure of a power electronic assembly of an embodiment of the invention with parts of the structure separated, and
Figure 2 shows the basic structure of Figure 1 as assembled.

### DETAILED DESCRIPTION OF THE INVENTION

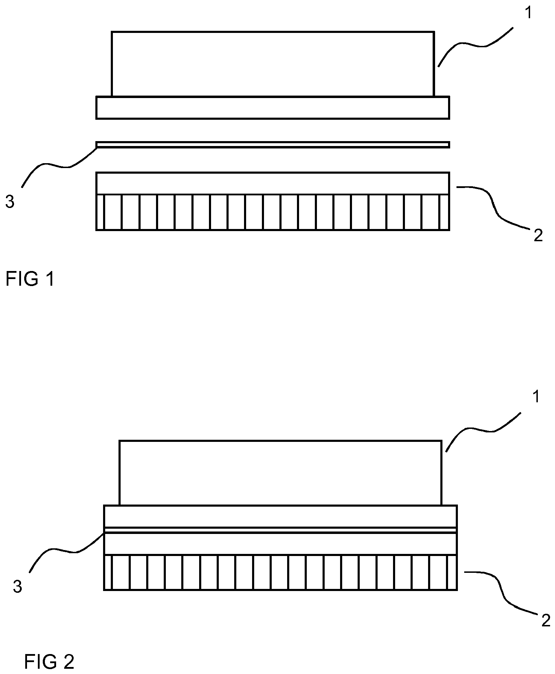

Figures 1 and 2 show a basic structure of a power electronic assembly according to an embodiment. In Figure 1 the main parts of the structure are shown as separated from each other whereas in Figure 2, the assembly is completed. The power electronic assembly comprises a power electronic module 1, cooling arrangement 2 and a thermal interface material 3 comprising an aluminium foil having a polymer coating. The power electronic module is a component enclosing multiple of power electronic switches. Such modules are used in building power electronic devices which large currents are switched and which use high voltages. Typical way of operating such power semiconductor switches is to have the component either fully conducting or blocking such that current is flowing through the component only when the voltage across the component is close to zero. Although the components are controlled in such a manner, that losses are minimized, some losses are incurring both during the switching instants and during conduction. The losses of the switch components cause the module to generate heat which can be detrimental to the components if not removed from the module. The Figures 1 and 2 are presented as examples for better understanding the idea of the invention. It should be noted that the Figures 1 and 2 do not present the components of the assembly in scale. For example, the thermal interface material 3 is shown as a thick block in the Figures for illustrative purposes.

For removing the heat from the modules, the modules are typically structured internally in such a manner that the heat is conveyed to the baseplate of the module and the temperature of the switch components can be kept within allowable limits by removing the heat from the component through the base plate. The baseplate is integral part of the module and is typically metallic to enable to transfer heat via the baseplate. The physical length of the baseplate is in the range of hundreds of millimetres.

For removal of the heat the bottom plate is mechanically connected to a mating surface of a cooling arrangement. The cooling arrangement thus has a surface that can receive the heat from the power electronic module and to further transfer the heat to a heat transfer medium, which may be liquid or air. In liquid cooled cooling arrangements a cooling liquid is flowing in channels or piping inside a metallic block near the cooling surface. In air cooled cooling arrangements the cooling arrangement comprises a large surface area in connection with surrounding air. The heat is removed to the surrounding air from the surface of the cooling arrangement and typically a large surface are is obtained by using fins or ribs and the removal of heat may be increased by using blowers to keep the air moving in the fins or ribs.

According to the present invention, the power electronic assembly comprises a thermal interface material arranged between the bottom surface of the power electronic module and the cooling surface of the cooling arrangement to transfer heat from the power electronic module to the cooling arrangement, the thermal interface material comprises an aluminium foil having a polymer coating. The bottom surface referred above is either a surface of the base plate or a surface of the substrate if the module is built without a base plate.

The aluminium foil having a polymer coating is in form of a separate layer that can be placed between the bottom surface and cooling surface during the installing of the assembly. The thickness of the aluminium foil is preferably in the range of 100 µm to 300 µm and the thickness of the polymer coating is in the range of 10 µm to 50 µm.

According to an embodiment of the invention, only one surface of the aluminium foil is coated with polymer coating. When assembled, the coated surface may face either the base plate or the cooling surface of the cooling arrangement. Preferably, the aluminium foil comprises polymer coating on both surfaces and thereby polymer coating faces both the base plate and the cooling surface. In case of a power electronic module without a base plate, the polymer layer of the thermal interface material is set against the surface of the substrate.

Further, according to another embodiment, the thermal interface material comprises multiple layers of aluminium foils with polymer coating. For example, the thermal interface material may be composed of two aluminium layers having a polymer coating between the layers. Further, the aluminium layers comprise polymer coatings on top of the layered structure and on the bottom of the layered structure. According to this embodiment, the layered structure of the thermal interface material comprises layers polymer - aluminium - polymer - aluminium - polymer. Such layered structure may have more layers with same basic structure. Further, the polymer coatings are not required on the top of the structure or on the bottom of the structure, the top and bottom referring to the two surfaces of the layered structure that are to be placed against the base plate and the cooling surface.

The structure having multiple of layers of aluminium and polymer coating enable the thermal interface to fill the gaps between surfaces of the bottom surface of the module and the cooling surface as the structure has more elasticity than structure with lesser layers. Further, the thicker structure enables to provide more adaptation to possible deformations of the base plate of the module during its use.

Power electronic module operation and power cycling during the operation causes base plate to bend and/or twist. This means that distance between the power electric module base plate and the cooling surface varies thus causing varying thermal resistance between the parts. However, the material described above has specific properties that compensate the downside effects of the deforming base plate to power electronic module cooling.

The polymer coated surface of the aluminum foil is able to penetrate and fill surface structures of the base plate and the cooling surface. This property of the polymer coating assists in obtaining good heat transfer properties between the base plate and the cooling arrangement. Further, as the polymer coated surface fill surface structures of the abutting surface, the thermal interface material holds securely in place.

The power electronic assembly is typically employed in a power electronic device. The power electronic device of the invention comprises one or more power electronics assemblies of the invention. A power electronic device is, for example, a converter, an inverter, a frequency converter or any other high-power device. Typically a power electronics device is a device that outputs controlled voltage or current to be supplied to a load. The power electronic assembly contains electrical terminals, such as control terminals and output terminals, with which the power electronics assembly can be coupled to other circuit structures and to enable operation of the circuit.

The method of the invention enables to produce the power electronic assembly. In the method, a power electronic module and a cooling arrangement are provided. The power electronic module comprises a base plate and the cooling arrangement comprises a cooling surface. In the method, a thermal interface material comprising an aluminium foil having a polymer coating is provided between the bottom surface of the power electronic module and the cooling surface of the cooling arrangement.

The power electronic module is further fastened to the cooling arrangement using fastening means. The fastening means are preferably screws or bolts with which components of the assembly are held firmly together. The screws or bolts are tightened to a specified torque which depends on the module and is typically given by the manufacturer of the power electronic module. Typically the power electronic module comprises through holes through which bolts can be assembled. The cooling arrangement has corresponding threaded holes to which the bolts can attach such that the mating surfaces are firmly against each other. The assembly of the invention does not require any modifications to the base plate, cooling surface or to fastening of the module and the cooling arrangement. When the power electronic module has a base plate, the fixing screws typically penetrate through the base plate. However, with modules without base plate the attachment of the module with the cooling arrangement can be carried out by applying pressure from the top of the module, for example.

According to an embodiment of the invention the polymer coating is a polysiloxane coating. Polysiloxane is generally also called silicone. In an embodiment, the polysiloxane coating comprises one or more metal oxide additives. These additives include aluminium oxide and ferric oxide. The amount of additives by weight is preferably 10 - 30 % of aluminium oxide and 5 - 25 % by weight of ferric oxide. In an embodiment the coating comprises 20 % by weight of aluminium oxide and 15 % by weight of ferric oxide. An example of such polymer product suitable for use in present invention is manufactured by T-Global Technology CO., LTD with a product code L37-5S.

In the above description power electronic modules are described as having a bottom surface. The bottom surface refers to that part of the power electronic module which is intended to be set against the cooling surface of a cooling arrangement, such as heat sink. Depending on the type of the power electronic module the bottom surface is either the surface of a base plate or a surface of a substrate of the power electronic module. The surface of the substrate is the bottom surface in such types of modules that do not have a base plate. The thermal interface material used in the invention is similar with both types of modules, except for that when the bottom surface is the substrate, the thermal interface should be arranged with the polymer layer towards the substrate.

It will be obvious to a person skilled in the art that, as the technology advances, the inventive concept can be implemented in various ways. The invention and its embodiments are not limited to the examples described above but may vary within the scope of the claims.

## Claims

1. A power electronic assembly comprising a power electronic module (1) incorporating multiple of semiconductor power electronic switch components, the power electronic module comprising a bottom surface,
the power electronic assembly comprises further a cooling arrangement (2) for cooling the power electronic module, the cooling arrangement comprising a cooling surface adapted to be attached against the bottom surface of the power electronic module, wherein
the power electronic assembly comprises further a thermal interface material (3) arranged between the bottom surface of the power electronic module and the cooling surface of the cooling arrangement to transfer heat from the power electronic module to the cooling arrangement, the thermal interface material comprises an aluminium foil having a polymer coating,
wherein the thermal interface material (3) comprises multiple layers of aluminium foils with polymer coating.

2. A power electronic assembly according to claim 1, wherein the polymer coating is arranged on one side of the aluminium foil.

3. A power electronic assembly according to claim 1, wherein the polymer coating is arranged on both sides of the aluminium foil.

4. A power electronic assembly according to any one of previous claims 1 to 3, wherein the thickness of the aluminium foil is in in the range of 100 µm to 300 µm.

5. A power electronic assembly according to any one of previous claims 1 to 4, wherein the thickness of the polymer coating is in the range of 10 µm to 50 µm.

6. A power electronic assembly according to claim 1, wherein the thermal interface material comprises two aluminium foils and a polymer coating between the aluminium foils, wherein at least one of the aluminium foils comprises polymer coating on top of the aluminium foil.

7. A power electronic assembly according to any one of the previous claims 1 to 6, wherein at least one of the multiple of semiconductor power electronic components of the power electronic module is rated to a current in the range of hundreds of amperes.

8. A power electronic assembly according to any one of the previous claims 1 to 7, wherein the length of the bottom surface of the power electronic module is in the range of over 100 millimeters.

9. A power electronic assembly according to any one of the previous claims 1 to 8, wherein the bottom surface of the power electronic module consists of a surface of a base plate of the power electronic module.

10. A power electronic assembly according to any one of the previous claims 1 to 8, wherein the bottom surface of the power electronic module consists of a surface of a substrate of the power electronic module.

11. A power electronic assembly according to any one of the previous claims 1 to 10, wherein the polymer coating is a polysiloxane coating.

12. A power electronic assembly according to claim 11, wherein the polysiloxane coating comprises one or more metal oxide additives, such as aluminium oxide and/or ferric oxide.

13. A power electronic assembly according to claim 12, wherein polysiloxane coating comprises 10 - 30 % by weight of aluminium oxide and/or 5 - 25 % by weight of ferric oxide.

14. A power electronic device comprising one or more power electronic assemblies according to any one of the previous claims 1 to 13.

15. A power electronic device according to claim 14, wherein the power electronic device is a frequency converter.

16. A method of producing a power electronic assembly comprising the steps of
providing a power electronic module (1) incorporating multiple of semiconductor power electronic switch components, the power electronic module comprising a bottom surface,
providing a cooling arrangement (2) for cooling the power electronic module, the cooling arrangement comprising a cooling surface adapted to be attached against the bottom surface of the power electronic module,
providing a thermal interface material (3) comprising an aluminium foil having a polymer coating between the bottom surface of the power electronic module and the cooling surface of the cooling arrangement, wherein the thermal interface material comprises multiple layers of aluminium foils with polymer coating, and
fastening the power electronic module to the cooling arrangement using fastening means.

## Patentansprüche

1. Leistungselektronische Baugruppe, umfassend ein Leistungselektronikmodul (1), das mehrere Halbleiterleistungselektronik-Schaltkomponenten umfasst, wobei das Leistungselektronikmodul eine Bodenfläche aufweist,
die leistungselektronische Baugruppe weiterhin eine Kühlanordnung (2) zum Kühlen des Leistungselektronikmoduls aufweist, wobei die Kühlanordnung eine Kühlfläche aufweist, die dazu eingerichtet ist, an der Bodenfläche des Leistungselektronikmoduls angebracht zu werden, wobei
die leistungselektronische Baugruppe ferner ein zwischen der Bodenfläche des Leistungselektronikmoduls und der Kühlfläche der Kühleinrichtung angeordnetes thermisches Grenzflächenmaterial (3) zur Übertragung von Wärme von dem Leistungselektronikmodul auf die Kühlanordnung umfasst, wobei das thermische Grenzflächenmaterial eine Aluminiumfolie mit einer Polymerbeschichtung umfasst und
das thermische Grenzflächenmaterial (3) mehrere Schichten aus Aluminiumfolien mit Polymerbeschichtung umfasst.

2. Leistungselektronische Baugruppe nach Anspruch 1, bei der die Polymerbeschichtung auf einer Seite der Aluminiumfolie angeordnet ist.

3. Leistungselektronische Baugruppe nach Anspruch 1, bei der die Polymerbeschichtung auf beiden Seiten der Aluminiumfolie angeordnet ist.

4. Leistungselektronische Baugruppe nach einem der vorhergehenden Ansprüche 1 bis 3, bei der die Dicke der Aluminiumfolie im Bereich von 100 µm bis 300 µm liegt.

5. Leistungselektronische Baugruppe nach einem der vorhergehenden Ansprüche 1 bis 4, bei der die Dicke der Polymerbeschichtung im Bereich von 10 µm bis 50 µm liegt.

6. Leistungselektronische Baugruppe nach Anspruch 1, bei der das thermische Grenzflächenmaterial zwei Aluminiumfolien und eine Polymerbeschichtung zwischen den Aluminiumfolien umfasst, wobei wenigstens eine der Aluminiumfolien eine Polymerbeschichtung auf der Aluminiumfolie umfasst.

7. Leistungselektronische Baugruppe nach einem der vorhergehenden Ansprüche 1 bis 6, bei der wenigstens eines der Mehrzahl von elektronischen Halbleiterbauelementen des Leistungselektronikmoduls einem Strom im Bereich von Hunderten von Ampere zugeordnet ist.

8. Leistungselektronische Baugruppe nach einem der vorhergehenden Ansprüche 1 bis 7, bei dem die Länge der Bodenfläche des Leistungselektronikmoduls im Bereich von über 100 Millimetern liegt.

9. Leistungselektronische Baugruppe nach einem der vorhergehenden Ansprüche 1 bis 8, bei der die Bodenfläche des Leistungselektronikmoduls aus einer Oberfläche einer Grundplatte des Leistungselektronikmoduls besteht.

10. Leistungselektronische Baugruppe nach einem der vorhergehenden Ansprüche 1 bis 8, bei dem die Bodenfläche des Leistungselektronikmoduls aus einer Oberfläche eines Substrats des Leistungselektronikmoduls besteht.

11. Leistungselektronische Baugruppe nach einem der vorhergehenden Ansprüche 1 bis 10, bei der die Polymerbeschichtung eine Polysiloxanbeschichtung ist.

12. Leistungselektronische Baugruppe nach Anspruch 11, bei der die Polysiloxanbeschichtung einen oder mehrere Metalloxidzusätze wie Aluminiumoxid und/oder Eisenoxid umfasst.

13. Leistungselektronische Baugruppe nach Anspruch 12, bei der die Polysiloxanbeschichtung 10-30 Gew.-% Aluminiumoxid und/oder 5-25 Gew.-% Eisenoxid enthält.

14. Leistungselektronisches Gerät mit einer oder mehreren leistungselektronischen Baugruppen nach einem der vorhergehenden Ansprüche 1 bis 13.

15. Leistungselektronisches Gerät nach Anspruch 14, wobei das leistungselektronische Gerät ein Frequenzwandler ist.

16. Verfahren zur Herstellung einer leistungselektronischen Baugruppe, umfassend folgende Schritte:
Bereitstellen eines Leistungselektronikmoduls (1), das mehrere Halbleiterleistungselektronik-Schaltkomponenten umfasst, wobei das Leistungselektronikmodul eine Bodenfläche aufweist,
Bereitstellen einer Kühlanordnung (2) zum Kühlen des Leistungselektronikmoduls, wobei die Kühlanordnung eine Kühlfläche aufweist, die dazu eingerichtet ist, an der Bodenfläche des Leistungselektronikmoduls angebracht zu werden,
Bereitstellen eines thermischen Grenzflächenmaterials (3) mit einer Aluminiumfolie mit einer Polymerbeschichtung zwischen der Bodenfläche des Leistungselektronikmoduls und der Kühlfläche der Kühlanordnung, wobei das thermische Grenzflächenmaterial mehrere Schichten aus Aluminiumfolien mit Polymerschicht umfasst, und
Befestigen des Leistungselektronikmoduls an der Kühlanordnung mittels Befestigungsmitteln.

## Revendications

1. Ensemble d'électronique de puissance comprenant un module d'électronique de puissance (1) comprenant plusieurs composants de commutation d'électronique de puissance à semi-conducteurs, le module d'électronique de puissance comprenant une surface inférieure,
l'ensemble d'électronique de puissance comprenant en outre un ensemble de refroidissement (2) destiné à refroidir le module d'électronique de puissance, l'ensemble de refroidissement comprenant une surface de refroidissement adaptée pour être fixée contre la surface inférieure du module d'électronique de puissance, dans lequel
l'ensemble d'électronique de puissance comprend en outre un matériau d'interface thermique (3) prévu entre la surface inférieure du module d'électronique de puissance et la surface de refroidissement de l'ensemble de refroidissement afin de transférer la chaleur entre le module d'électronique de puissance et l'ensemble de refroidissement, le matériau d'interface thermique comprenant une feuille d'aluminium ayant un revêtement polymère,
dans lequel le matériau d'interface thermique (3) comprend plusieurs couches de feuilles d'aluminium avec un revêtement polymère.

2. Ensemble d'électronique de puissance selon la revendication 1, dans lequel le revêtement polymère est disposé sur un côté de la feuille d'aluminium.

3. Ensemble d'électronique de puissance selon la revendication 1, dans lequel le revêtement polymère est prévu des deux côtés de la feuille d'aluminium.

4. Ensemble d'électronique de puissance selon l'une quelconque des revendications 1 à 3, dans lequel l'épaisseur de la feuille d'aluminium est de l'ordre de 100 µm à 300 µm.

5. Ensemble d'électronique de puissance selon l'une quelconque des revendications 1 à 4, dans lequel l'épaisseur du revêtement polymère est de l'ordre de 10 µm à 50 µm.

6. Ensemble d'électronique de puissance selon la revendication 1, dans lequel le matériau d'interface thermique comprend deux feuilles d'aluminium et un revêtement polymère entre les feuilles d'aluminium, dans lequel au moins l'une des feuilles d'aluminium comprend un revêtement polymère sur le dessus de la feuille d'aluminium.

7. Ensemble d'électronique de puissance selon l'une quelconque des revendications 1 à 6, dans lequel au moins l'un des multiples composants d'électronique de puissance à semi-conducteurs du module d'électronique de puissance est calibré sur un courant de l'ordre de plusieurs centaines d'ampères.

8. Ensemble d'électronique de puissance selon l'une quelconque des revendications 1 à 7, dans lequel la longueur de la surface inférieure du module d'électronique de puissance est de l'ordre de plus de 100 millimètres.

9. Ensemble d'électronique de puissance selon l'une quelconque des revendications 1 à 8, dans lequel la surface inférieure du module d'électronique de puissance se compose d'une surface d'une plaque de base du module d'électronique de puissance.

10. Ensemble d'électronique de puissance selon l'une quelconque des revendications 1 à 8, dans lequel la surface inférieure du module d'électronique de puissance se compose d'une surface d'un substrat du module d'électronique de puissance.

11. Ensemble d'électronique de puissance selon l'une quelconque des revendications 1 à 10, dans lequel le revêtement polymère est un revêtement en polysiloxane.

12. Ensemble d'électronique de puissance selon la revendication 11, dans lequel le revêtement en polysiloxane comprend un ou plusieurs additifs d'oxyde métallique, comme de l'oxyde d'aluminium et/ou un oxyde ferrique.

13. Ensemble d'électronique de puissance selon la revendication 12, dans lequel le revêtement polysiloxane comprend 10 à 30% en poids d'oxyde d'aluminium et/ou 5 à 25% en poids d'oxyde ferrique.

14. Dispositif d'électronique de puissance comprenant un ou plusieurs ensembles d'électronique de puissance selon l'une quelconque des revendications 1 à 13.

15. Dispositif d'électronique de puissance selon la revendication 14, dans lequel le dispositif d'électronique de puissance est un convertisseur de fréquence.

16. Procédé de fabrication d'un ensemble d'électronique de puissance comprenant les étapes consistant à
prévoir un module d'électronique de puissance (1) comprenant plusieurs composants de commutation d'électronique de puissance à semi-conducteurs, le module d'électronique de puissance comprenant une surface inférieure,
prévoir un ensemble de refroidissement (2) destiné à refroidir le module d'électronique de puissance, l'ensemble de refroidissement comprenant une surface de refroidissement adaptée pour être fixée contre la surface inférieure du module d'électronique de puissance,
prévoir un matériau d'interface thermique (3) comprenant une feuille d'aluminium ayant un revêtement polymère entre la surface inférieure du module d'électronique de puissance et la surface de refroidissement de l'ensemble de refroidissement, dans lequel le matériau d'interface thermique comprend plusieurs couches de feuilles d'aluminium avec un revêtement polymère, et
fixer le module d'électronique de puissance sur l'ensemble de refroidissement à l'aide d'un moyen de fixation.
